# EUROPEAN PATENT APPLICATION

(11) **EP 4 556 143 A1**
(43) Date of publication of application: **21.05.2025**
(21) Application number: 24200668.2
(22) Date of filing: 16.09.2024
(51) Int. Cl.: B22F 1/07, B22F 1/142, B22F 9/04, B22F 9/08, C04B 35/453, C04B 35/462, C04B 35/626, C22C 29/12, C22C 32/00, C30B 21/00, B22F 1/052

(54) **METHOD OF OBTAINING EUTECTIC MATERIAL IN THE FORM OF MICROSPHERES AND THE MATERIAL OBTAINED BY THIS METHOD**

(30) Priority: 15.09.2023 PL 44611123; 13.09.2024 PL 44982524
(71) Applicant: Ensemble3 spolka z ograniczona odpowiedzialnoscia, 01-919 Warszawa (PL)
(72) Inventor: Sadecka, Katarzyna, 04-164 Warszawa (PL); Paszke, Piotr, 64-361 Miedzichowo (PL); Pawlak, Dorota Anna, 01-885 Warszawa (PL); Henein, Hani, Edmonton, T6R2J1 (CA)
(74) Representative: JD&P Patent Attorneys Joanna Dargiewicz & Partners

(57) **Abstract**

The subject of the invention is a method for obtaining eutectic material in the form of microspheres, characterised in that it comprises the following steps:
(a) melting of a eutectic mixture of metal oxides of eutectic composition or of a eutectic mixture of metal oxide-metal composition in which the metal oxide constitutes the topological phase and the precipitating phase is the metal oxide or metal, which are prepared in molar proportions of 0.01-99.99% of the topological phase and 0.01-99.99% of the precipitating phase, in proportion to 100%;
(b) Grinding the eutectic material of dielectric-dielectric or metal-dielectric eutectic material obtained in step (a) into powder;
(c) Obtaining microspheres by rapid melting of the powder material, at 600-1700 °C in an atmosphere of nitrogen, argon or helium, or rapid crystallisation of droplets of previously melted powder material, at 600-2000 °C in an atmosphere of nitrogen, argon or helium.

## Description

The subject of the invention is a method for obtaining eutectic material in the form of microspheres, and the material obtained by this method. The invention has applications in photonics and in plasmonics, which is based on the use of vibrations of free carriers in metallic structures in interaction with an electromagnetic wave. The invention may have applications in many different fields, such as energy conversion, energy storage, protection of documents and other objects, 3D printing and others.

A eutectic material consisting of two components is known from patent PL227901: 82.0-86.0 mol of Bi₂O₃ constituting a dielectric matrix, with a positive real electrical permeability Re(eps)>0 for the electromagnetic wavelength range λ 172 nm-258 nm and above 326 nm, and 14.0-18.0 mol of Ag constituting metallic or semiconducting separations with a resistivity of 15, 87 nΩm, with a negative real electrical permeability Re(eps)<0 for the same wavelength range A 172 nm- 258 nm and above 326 nm, advantageously with low optical losses, i.e. an imaginary electrical permeability value Im(eps) of 1.79-3.6 F/m and from 0.579 F/m for Re(eps)<0. With that said, the Bi₂O₃-Ag eutectic described in PL227901 exhibits micro- and nano-separations of silver. Its microstructure consists of a three-dimensional network of Ag precipitates in the form of triangular shapes with sharp corners connected to dozens of micrometre-sized precipitates on the nanometre scale, all embedded in the matrix.

The aim of the invention was to develop a new and efficient way of obtaining eutectic material in the form of microspheres.

The essence of the invention is a method for obtaining eutectic material in the form of microspheres, characterised in that it comprises the following steps:
(a) melting of a eutectic mixture of metal oxides of eutectic composition or of a eutectic mixture of metal oxide-metal composition in which the metal oxide constitutes the topological phase and the precipitating phase is the metal oxide or metal, which are prepared in molar proportions of 0.01-99.99% of the topological phase and 0.01-99.99% of the precipitating phase, in proportion to 100%;
(b) Grinding the eutectic material of dielectric-dielectric or metal-dielectric eutectic material obtained in step (a) into powder;
(c) Obtaining microspheres by rapid melting of the powder material, at 600-1700 °C in an atmosphere of nitrogen, argon or helium, or rapid crystallisation of droplets of previously melted powder material, at 600-2000 °C in an atmosphere of nitrogen, argon or helium.

In one embodiment, the topological phase or the precipitated phase is a metal oxide, advantageously selected from the group comprising Bi₂O₃, ZnO, ZnWO₄, SrTiO₃, TiO₂ and/or the metal is selected from the group comprising Ag.

In one embodiment, the topological phase is Bi₂O₃, while the precipitate phase is Ag, which are prepared in molar proportions of 15.4 mol% Ag and 84.6 mol% Bi₂O₃.

In one embodiment, that in step (a) the growth rate is 0.05-15 mm/s and/or in step (c) the solidification rate is <0.5m/s.

In one embodiment, that it comprises a step (b') in which the powder material is separated on sieves and/or a step (d) in which the micro- or nanospheres obtained in step (c) are separated on sieves, advantageously the average size of the microspheres being in the range of 20 µm to 200 µm, advantageously 36 µm to 180 µm.

In one embodiment, a method wherein the metal oxide components of a eutectic composition or a metal oxide-metal eutectic mixture, wherein the metal oxide is the topological phase while the precipitate phase is the metal oxide or metal, prepared in molar proportions of 0, 01-99.99% for the topological phase and 0.01-99.99% for the precipitate phase, in proportion to 100% of the eutectic, are mixed and melted in a crucible and turned into droplets which, while falling in an inert atmosphere, are left to cool until solidification; the resulting microspheres are melted at 600-1700°C in a nitrogen, argon or helium atmosphere or by rapid crystallisation of droplets of previously melted powdered material at 600-2000°C in a nitrogen, argon or helium atmosphere.

In one embodiment, the topological phase or the precipitated phase is a metal oxide, advantageously selected from the group comprising Bi₂O₃, ZnO, ZnWO₄, SrTiO₃, TiO₂ and/or the metal is selected from the group comprising Ag.

In one embodiment, the topological phase is Bi₂O₃, while the precipitate phase is Ag, which are prepared in molar proportions of 15.4 mol% Ag and 84.6 mol% Bi₂O₃.

In one embodiment, in step (a) the growth rate is 0.05-15 mm/s and/or in step (c) the solidification rate is <0.5m/s.

In one embodiment, it comprises a step (b') in which the powder material is separated on sieves and/or a step (d) in which the micro- or nanospheres obtained in step (c) are separated on sieves, advantageously the average size of the microspheres being in the range of 20 µm to 200 µm, advantageously 36 µm to 180 µm.

The other essence of the invention is a metal-dielectric or dielectric-dielectric eutectic material obtained by any of the preceding claims 1 - 5 or by the method described in claims 6-10, characterised in that it is in the form of microspheres with a size of 20-200 µm and with a homogeneous and directed microstructure.

In one embodiment, the dielectric is selected from the group comprising Bi₂O₃, ZnO, ZnWO₄, SrTiO₃, TiO₂ and/or the metal is selected from the group comprising Ag.

In one embodiment, it constitutes Bi₂O₃-Ag microspheres comprising 82.0-86.0 mol of Bi₂O₃ constituting the dielectric matrix.

In one embodiment, it constitutes ZnO-ZnWO₄ microspheres comprising 63.0-67.0 mol% ZnO and proportionally 33.0 - 37.0 mol% WO₃.

In one embodiment, it constitutes SrTiO₃-TiO₂ microspheres comprising 21.0 - 25.0 mol% SrO and proportionally 75.0 - 79 mol% TiO₂.

### Detailed description of the invention

The method according to the invention makes it possible to obtain directed metal-dielectric and dielectric-dielectric eutectic structures in the form of microspheres with homogeneous micro- or nanostructures using a rapid crystallization mechanism.

The production of eutectic composites in the form of microspheres in step c) of the method according to the invention consists in the rapid melting of a mixture of eutectic composition in the form of a powder obtained in step b) of the method according to the invention, which, under the influence of gravity, passes through a tube placed in a zone of a given temperature and is then cooled at a rate that allows crystallization to take place.

In step c) of the method according to the invention, a material of eutectic composition in powder form is poured into a container located at the top of the apparatus. Then, the material, under the influence of gravity and flowing gas, first moves through a zone with a preset temperature at least equal to the eutectic temperature, then undergoing melting. Then, passing through a zone with a lower temperature, it crystallises in the form of microspheres. At the very bottom, there is a collector to collect the microspheres.

In an advantageous embodiment, a material of eutectic composition, preferably in the form of a powder in an amount of up to 1g, is poured into the upper container.

A mixture of metal oxides of eutectic composition or a metal oxide-metal eutectic mixture is advantageously used as the material subjected to the process for obtaining microspheres.

Advantageously, high-purity nitrogen, argon or helium is used as the process gas.

The method according to the invention makes it possible to obtain metal-dielectric and dielectric-dielectric eutectic materials in the form of microspheres with homogeneous and directed micro- and nanostructures.

With rapid solidification below 0.5 m/s and faster cooling, the structure in the microspheres will be nanometre-sized. This allows us to observe unique optical effects in the wavelength range of 200-900 nm. The ability to scale the eutectic structure from micro to nano size will allow control of the wavelength at which EM properties will be observed, potentially from UV to far infrared.

The invention provides the following advantages:
- The invention will find application in photonics and plasmonics, which is based on the use of vibrations of free carriers in metallic structures in interactions with an electromagnetic wave as well as the invention can be applied in many different fields such as energy conversion, energy storage, protection of documents and other objects, 3D printing and others;
- The invention provides the ability to scale the eutectic structure from micro to nano size, which in turn translates into obtaining different optical effects and controlling these effects potentially from UV to far infrared;
- The eutectic material in microsphere form may have different optical properties than the same material in volumetric form.

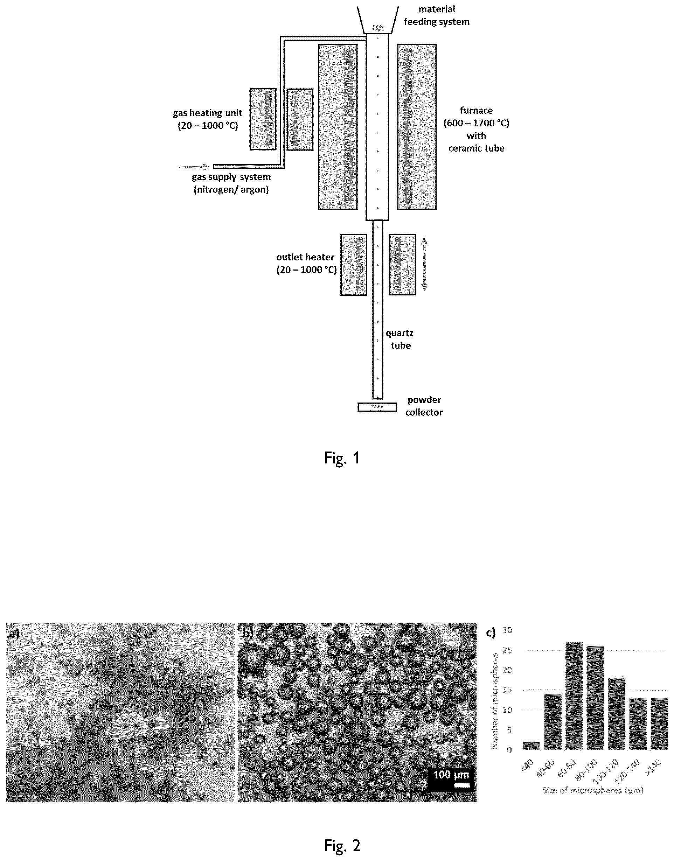

The invention is shown in the following examples of its implementation, without limiting the scope of its application, based on the drawing in which the
fig. 1 shows an example, known from the state of the art, of a device for carrying out the first variant of stage c) of the method according to the invention - i.e. the fast melting stage by the method according to the invention, which has been modified by additional heating of the gas and additional heating of the quartz tube;
fig. 2 shows eutectic microspheres obtained by rapid melting by the method according to the invention (a-b) photographs of microspheres, (c) change in size of microspheres;

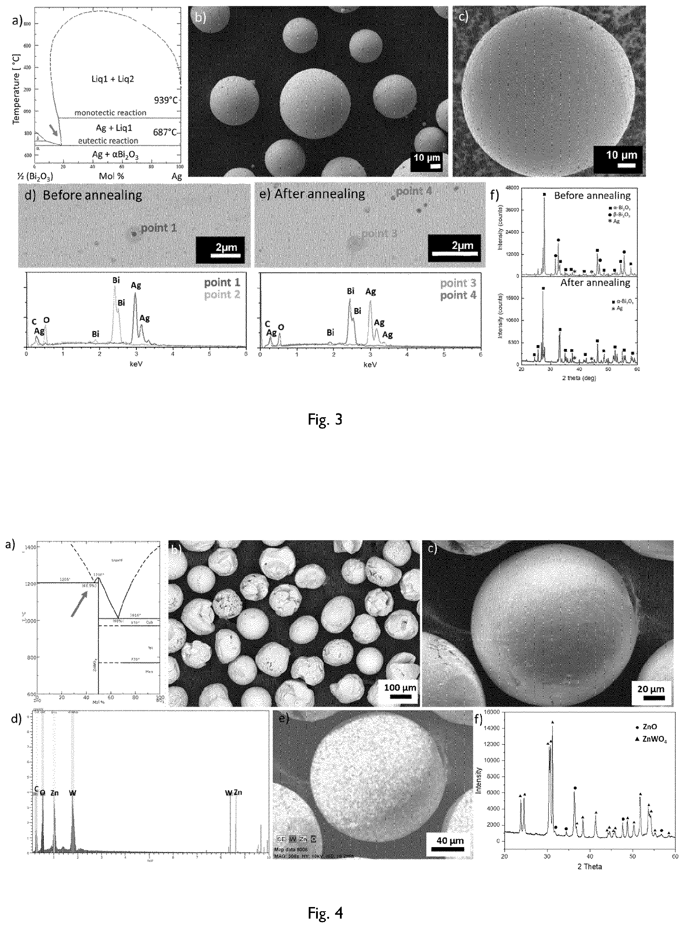

fig. 3 shows (a) phase diagram of eutectic Bi₂O₃-Ag material, (b) SEM micrographs of eutectic Bi₂O₃-Ag microspheres and (c) a single microsphere obtained in the rapid melting process by the method according to the invention, (d-e) phase analysis using energy dispersive X-ray spectroscopy and (f) X-ray diffraction of microspheres obtained by the method according to the invention before and after annealing in air;
fig. 4 shows (a) phase diagram of ZnO-ZnWO₄ eutectic material, (b) SEM micrographs of ZnO-ZnWO₄ eutectic microspheres and (c) a single microsphere obtained by rapid melting according to the invention, (d-e) phase analysis together with a map using energy dispersive X-ray spectroscopy, and (f) X-ray diffraction of microspheres

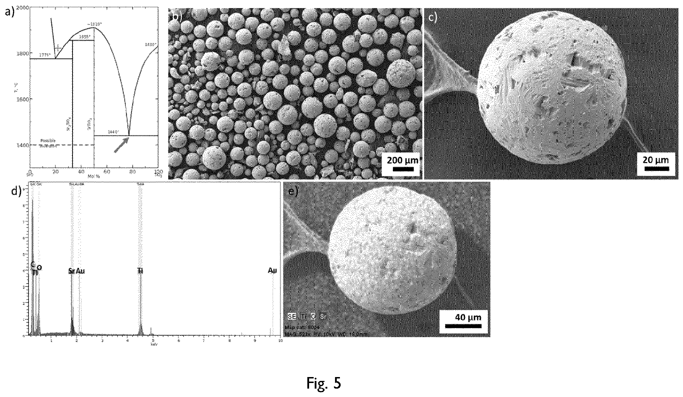

fig. 5 depicts a) phase diagram of the SrTiO₃-TiO₂ eutectic material, b) SEM micrographs of SrTiO₃-TiO₂ eutectic microspheres and c) a single microsphere obtained in the rapid melting process by the method according to the invention, d-e) phase analysis together with a map using energy dispersive X-ray spectroscopy.

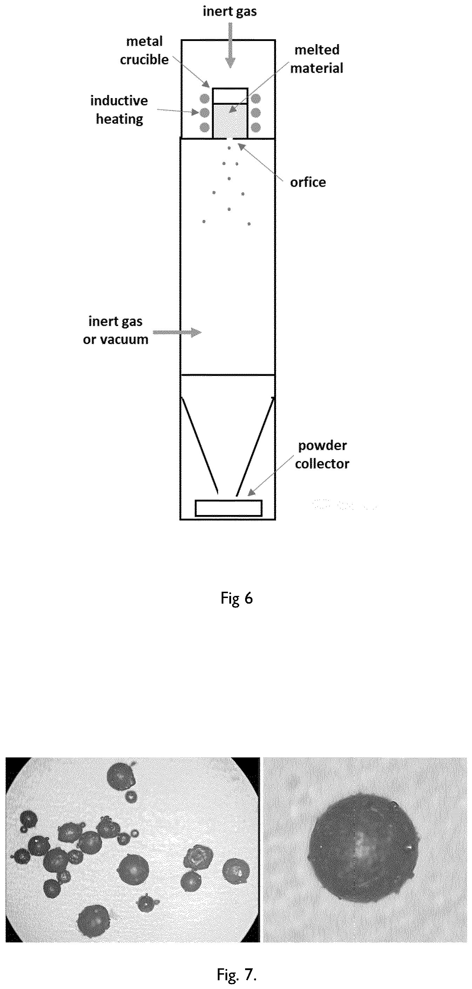

fig 6. shows a device for carrying out the fast droplet crystallisation step - i.e. a variant of the second step (c) of the method according to the invention.
fig 7. shows an optical microscope photograph of Bi₂O₃-Ag eutectic microspheres and a single microsphere obtained by rapid droplet crystallisation - i.e. a variant of the second step (c) of the method according to the invention.

The examples given below show the method according to the invention in specific cases of its use, without limiting the scope of its application, based on a drawing showing an example diagram of a high-temperature tube furnace.

### Example 1

In this unrestricted manufacturing example, the method for obtaining eutectic material according to the invention produces eutectic microspheres and includes the following steps:

### Stage A) Melting of a eutectic mixture in which one phase is the topological phase Bi₂O₃ and the other is Ag

In this unrestricted fabrication example, the eutectic structure was made in a bismuth-silver system in which one phase is Bi₂O₃ and the other phase is Ag. These phases are prepared in molar proportions of 15.4 mol% Ag and 84.6 mol% Bi₂O₃.

On the other hand, the eutectic monocrystal was obtained by directional crystallisation using a micro-pulling method based on the method of preparation under patent (PL227901), as briefly characterised below:
In the directional crystallisation step (micropulling down method), the growth rate is approximately 0.05 to 15 mm/s, resulting in phase sizes in the order of micrometres.

In this implementation example, the growth rate was 1-7 mm/s and a nitrogen atmosphere was used during the process.

In a ceramic mortar, the components are mashed in suspension in propanol with 15.4% mol Ag with a melting point of 961.98°C and 84.6% mol Bi₂O₃ with a melting point of 817°C. The resulting material is then heated in a resistance furnace to 100°C to evaporate the propanol. The material thus prepared is placed in a crucible, which is then assembled in a system for directional microextraction from the melt. The main process for obtaining the rod is carried out in the temperature range 650-700°C.

### Step B) Grinding the eutectic material obtained in step a) into powder

In this implementation example, the eutectic material obtained in step a) is ground in a ceramic mortar, while an agate mortar can also be used.

### Step C) Obtaining microspheres by rapid melting of the powder material obtained in step b)

This step is based on the rapid melting of the powder material obtained in step (b) in a device, which passes by gravity through a tube located in a zone with a fixed temperature, which finally falls into a microsphere collector.

However, this example uses a state-of-the-art device, shown schematically in fig. 1, which consists of a main furnace with a 20 mm diameter vertical reactor, which can operate at high temperatures (600-1700 °C). Below the main furnace is a quartz tube with an additional outlet heater. At the end of the tube is a tank. The powdered material is placed in the feeder, which is located above the main furnace. The material feed system ensures a stable and continuous dosage of the correct amount of material to start the process. During the process, gas is supplied; it is possible to connect different gases (nitrogen, argon, helium). The gas is heated by an additional heating unit.

In this unrestricted execution example, rapid melting is carried out at 1500 °C.

The method according to the invention makes it possible to obtain a Bi₂O₃-Ag eutectic material consisting of 82.0-86.0 mol Bi₂O₃ constituting a dielectric matrix, with a positive real electrical permeability Re(eps)>0 for the electromagnetic wavelength range λ 172 nm-258 nm and above 326 nm and 14.0-18, 0 mol of Ag constituting a metallic or semiconducting spin-off with a resistivity of 15.87 nΩm, with a negative real electrical permeability Re(eps)<0 for the same wavelength range λ 172 nm-258 nm and above 326 nm, advantageously with low optical losses, i.e. an imaginary value of the electrical permeability Im(eps) of 1.79-3.6 F/m and from 0.579 F/m for Re(eps).

The microspheres thus obtained are subjected to heat treatment in an oxidising atmosphere. The annealing is carried out at 600°C for at least 4 hours. At the same time, the Bi₂O₃-Ag eutectic microspheres obtained in this implementation example are characterised by the following plasmonic properties, in the visible range.

### Example 2

In this implementation example, eutectic microspheres according to the invention were obtained by the method according to example 1.

### Microsphere size analysis

By the method according to Example 1, eutectic Bi₂O₃-Ag microspheres of different sizes were obtained, as shown in fig. 2, which is related to the different fineness of the material before the process. The size of the microspheres obtained ranged from ~30 to ~200 µm, with an average size of ~100 µm. Based on the analysis of the diameter of the microspheres using an optical microscope, it was calculated that the largest number of microspheres were between 60 and 100 µm in size.

### Eutectic microstructure

Microstructure studies were carried out using an SEM microscope with EDS analysis. The microspheres obtained have a structure characteristic of eutectic material as shown in fig. 3.

### Example 3.

Method as in example 1, except that it includes step b') in which the powder material is sieved through sieving screens. In this non-limiting implementation example, sieves with a mesh of 36 - 180 µm are used.

### Example 4.

Method as in example 1, except that it includes step (d) in which the microspheres obtained in step (c) are sieved through sieve screens. In this non-limiting example of implementation, sieves with a mesh of 36 -180 µm are used.

### Example 5.

Method as in example 1, except that it includes step b') in which the powder material is sieved through sieving screens. In this non-limiting manufacturing example, sieves with a mesh of 36 - 180 µm are used and step (d) in which the microspheres obtained in step (c) are sieved through sieving screens. In this non-restrictive implementation example, sieves with a mesh of 36 -180 µm were used, but sieves with a mesh of 30-200 µm can also be used.

### Example 6.

Method as in example 1, except that the topological phase is ZnWO₄.
Eutectic: ZnO-ZnWO₄, Composition: 65 mol% ZnO, 35 mol% WO₃, Eutectic temp: 1205 °C
Rapid melting is carried out at 1450 °C.
(Only Bi₂O₃-Ag microspheres are subjected to additional annealing, ZnO-ZnWO₄ is not)

### Example 7.

Method as in example 1, except that the topological phase is SrTiO₃.
Eutectic: SrTiO₃-TiO₂, Composition: 23 mol % SrO, 77 mol % TiO₂, Eutectic temp: 1440 °C
Rapid melting is carried out at 1700 °C.
(Only Bi₂O₃-Ag microspheres are subjected to additional annealing, while SrTiO₃-TiO₂ is not).

### Example 8.

Method as in examples 1, 6, 7 except that step (c) involves rapid crystallisation of droplets of previously melted powder material, at a maximum temperature of 2000 °C in a nitrogen atmosphere. However, alternatively, an argon or helium atmosphere can be used. The process was carried out in an apparatus, a diagram of which is shown in fig. 5.

As indicated in fig. 5, the rapid solidification device consists of two parts: The main furnace will be equipped with an iridium crucible which will be placed in an induction coil, a gas will be supplied to the furnace which will push the material out through a hole in the bottom of the crucible. The furnace will operate at temperatures up to 2000 °C. Below the main furnace will be a 2-4m-long tube, which will also be equipped with gas or vacuum connections and a detachable microsphere catcher.

With that said, the rapid crystallisation method involves melting eutectic materials in a crucible. Rapid solidification of the molten material, which, as a result of the applied gas pressure, passes through a micrometre-sized hole at the bottom of the crucible, forming tiny droplets that solidify as they free-fall in a long tube (A. L. Greer, Materials Science and Engineering 1994, A178, 113; R.C. Toledo, J. S. Travelho, Ch. Y. An, I. N. Bandeira, Microgravity Sci. Technol. 2014; 26, 119).

### Example 9

In this non-limiting implementation example, the method for obtaining eutectic material according to the invention produces eutectic microspheres and proceeds as follows:
The components of metal oxides with a eutectic composition or metal oxide-metal eutectic mixture, where the metal oxide is the topological phase while the precipitate phase is the metal oxide or metal, are prepared in molar proportions of 0.01-99.99% for the topological phase and 0.01-99.99% for the precipitate phase, in proportion to 100% eutectics.

The above-mentioned components are then mixed and melted in a crucible and turned into droplets which, while falling in an inert atmosphere, are left to cool until solidification; the resulting microspheres are melted at 600-1700°C in an atmosphere of nitrogen, argon or helium or by rapid crystallisation of droplets of previously melted powdered material at 600-2000°C in an atmosphere of nitrogen, argon or helium.

The topological or precipitated phase is a metal oxide, advantageously selected from the group comprising Bi₂O₃.

The metal is Ag.

The eutectic material is Bi₂O₃-Ag microspheres comprising 82.0-86.0 mol of Bi₂O₃ constituting the dielectric matrix.

### Example 10

Method as in Example 9, except that the topological phase is Bi₂O₃ and the precipitate phase is Ag, which are prepared in molar proportions of 15.4 mol% Ag and 84.6 mol% Bi₂O₃.

### Example 11.

Method as in example 9, except that the powder material is sieved through sieve screens. In this non-limiting example of implementation, sieves with a mesh of 36 -180 µm are used and step (d) in which the microspheres obtained in step (c) are sieved through the screening sieves. In this non-restrictive implementation example, sieves with a mesh of 36 -180 µm were used, but sieves with a mesh of 20-200 µm can also be used.

### Example 12

In this implementation example, eutectic microspheres according to the invention were obtained by the method according to example 9.

### Analysis of microsphere size

Eutectic Bi₂O₃-Ag microspheres of different sizes were obtained by the method according to example 9, as shown in fig. 7. The size of the microspheres obtained ranged from ~30 to ~200 µm, with an average size of ~120 µm. Based on the analysis of the diameter of the microspheres using an optical microscope, it was calculated that the largest number of microspheres ranged in size from 100 - 150 µm.

### Example 13.

Method as in example 9, except that the topological phase is SrTiO₃
Eutectic: SrTiO₃-TiO₂, Composition: 21 mol % SrO, 79 mol % TiO₂, Eutectic temp: 1440 °C
Rapid melting is carried out at 1700 °C.
(Only Bi₂O₃-Ag microspheres are subjected to additional annealing, while SrTiO₃-TiO₂ is not).

### Example 14.

Method as in example 9, except that the topological phase is ZnWO₄.
Eutectic: ZnO-ZnWO₄, Composition: 67 mol% ZnO, 33 mol% WO₃, Eutectic temp: 1205 °C
Rapid melting is carried out at 1450 °C.
(Only Bi₂O₃-Ag microspheres undergo additional annealing, ZnO-ZnWO₄ does not).

## Claims

1. A method for obtaining eutectic material in the form of microspheres, **characterised in that** it comprises the following steps:
(d) melting of a eutectic mixture of metal oxides of eutectic composition or of a eutectic mixture of metal oxide-metal composition in which the metal oxide constitutes the topological phase and the precipitating phase is the metal oxide or metal, which are prepared in molar proportions of 0.01-99.99% of the topological phase and 0.01-99.99% of the precipitating phase, in proportion to 100%;
(e) Grinding the eutectic material of dielectric-dielectric or metal-dielectric eutectic material obtained in step (a) into powder;
(f) Obtaining microspheres by rapid melting of the powder material, at 600-1700 °C in an atmosphere of nitrogen, argon or helium, or rapid crystallisation of droplets of previously melted powder material, at 600-2000 °C in an atmosphere of nitrogen, argon or helium.

2. The method according to claim 1, **characterised in that** the topological phase or the precipitated phase is a metal oxide, advantageously selected from the group comprising Bi₂O₃, ZnO, ZnWO₄, SrTiO₃, TiO₂ and/or the metal is selected from the group comprising Ag.

3. The method according to claim 1, **characterised in that** the topological phase is Bi₂O₃, while the precipitate phase is Ag, which are prepared in molar proportions of 15.4 mol% Ag and 84.6 mol% Bi₂O₃.

4. The method according to any of the preceding claims 1 to 3 **characterised in that** in step (a) the growth rate is 0.05-15 mm/s and/or in step (c) the solidification rate is <0.5m/s.

5. The method according to any of the preceding claims 1 to 4, **characterised in that** it comprises a step (b') in which the powder material is separated on sieves and/or a step (d) in which the micro- or nanospheres obtained in step (c) are separated on sieves, advantageously the average size of the microspheres being in the range of 20 µm to 200 µm, advantageously 36 µm to 180 µm.

6. A method wherein the metal oxide components of a eutectic composition or a metal oxide-metal eutectic mixture, wherein the metal oxide is the topological phase while the precipitate phase is the metal oxide or metal, prepared in molar proportions of 0.01-99.99% for the topological phase and 0.01-99.99% for the precipitate phase, in proportion to 100% of the eutectic, are mixed and melted in a crucible and turned into droplets which, while falling in an inert atmosphere, are left to cool until solidification; the resulting microspheres are melted at 600-1700°C in a nitrogen, argon or helium atmosphere or by rapid crystallisation of droplets of previously melted powdered material at 600-2000°C in a nitrogen, argon or helium atmosphere.

7. The method according to claim 6, **characterised in that** the topological phase or the precipitated phase is a metal oxide, advantageously selected from the group comprising Bi₂O₃, ZnO, ZnWO₄, SrTiO₃, TiO₂ and/or the metal is selected from the group comprising Ag.

8. The method according to claim 6, **characterised in that** the topological phase is Bi₂O₃, while the precipitate phase is Ag, which are prepared in molar proportions of 15.4 mol% Ag and 84.6 mol% Bi₂O₃.

9. The method according to any of the preceding claims 6 to 8, **characterised in that** in step (a) the growth rate is 0.05-15 mm/s and/or in step (c) the solidification rate is <0.5m/s.

10. The method according to any of the preceding claims 6 to 9, **characterised in that** it comprises a step (b') in which the powder material is separated on sieves and/or a step (d) in which the micro- or nanospheres obtained in step (c) are separated on sieves, advantageously the average size of the microspheres being in the range of 20 µm to 200 µm, advantageously 36 µm to 180 µm.

11. A metal-dielectric or dielectric-dielectric eutectic material obtained by any of the preceding claims 1 - 5 or by the method described in claims 6 - 10, **characterised in that** it is in the form of microspheres with a size of 20-200 µm and with a homogeneous and directed microstructure.

12. The eutectic material according to claim 11, **characterised in that** the dielectric is selected from the group comprising Bi₂O₃, ZnO, ZnWO₄, SrTiO₃, TiO₂ and/or the metal is selected from the group comprising Ag.

13. The eutectic material according to claim 12, **characterised in that** it constitutes Bi₂O₃-Ag microspheres comprising 82.0-86.0 mol of Bi₂O₃ constituting the dielectric matrix.

14. The eutectic material according to claim 12, **characterised in that** it constitutes ZnO-ZnWO₄ microspheres comprising 63.0-67.0 mol% ZnO and proportionally 33.0 - 37.0 mol% WO₃.

15. The eutectic material according to claim. 12, **characterised in that** it constitutes SrTiO₃-TiO₂ microspheres comprising 21.0 - 25.0 mol% SrO and proportionally 75.0 - 79 mol% TiO₂.
